(19) Europäisches Patentamt | European Patent Office | Office européen des brevets

(11) **EP 3 724 919 B1**

(12) **EUROPEAN PATENT SPECIFICATION**

(45) Date of publication and mention
of the grant of the patent:
**01.12.2021 Bulletin 2021/48**

(21) Application number: **18830621.1**

(22) Date of filing: **14.12.2018**

(51) Int Cl.:
***H01L 27/146*** *(2006.01)*

(86) International application number:
**PCT/US2018/065679**

(87) International publication number:
**WO 2019/118840 (20.06.2019 Gazette 2019/25)**

(54) **CMOS IMAGE SENSOR INCLUDING STACKED SEMICONDUCTOR CHIPS AND READOUT CIRCUITRY INCLUDING A SUPERLATTICE AND RELATED METHODS**

CMOS-BILDSENSOR MIT GESTAPELTEN HALBLEITERCHIPS UND AUSLESESCHALTUNGEN MIT EINEM ÜBERGITTER UND ZUGEHÖRIGE VERFAHREN

CAPTEUR D'IMAGE CMOS COMPRENANT DES PUCES SEMI-CONDUCTRICES EMPILÉES ET UN ENSEMBLE CIRCUIT DE LECTURE COMPRENANT UN SUPER-RÉSEAU ET PROCÉDÉS ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.12.2017 US 201715843017**
**15.12.2017 US 201715842993**

(43) Date of publication of application:
**21.10.2020 Bulletin 2020/43**

(73) Proprietor: **Atomera Incorporated**
**Los Gatos, CA 95032 (US)**

(72) Inventors:
• **CHEN, Yi-Ann**
**Campbell, California 95008 (US)**
• **HUSAIN, Abid**
**San Jose, California 95125 (US)**
• **TAKEUCHI, Hideki**
**San Jose, California 95129 (US)**

(74) Representative: **Roberts, David**
**Page White & Farrer**
**Bedford House**
**John Street**
**London WC1N 2BF (GB)**

(56) References cited:
**EP-A1- 1 644 984      US-A1- 2015 008 482**
**US-A1- 2016 088 253**

• **Nuo Xu ET AL: "Silicon molecular beam epitaxy : symposium held April 29-May 3, 1991, Anaheim, California, U.S.A.", Silicon Molecular Beam Epitaxy Symposium. 29 April-3 May 1991 Anaheim, CA (in: Materials Research Society symposium proceedings), 1 January 1991 (1991-01-01), XP055565272, US ISBN: 978-1-55899-114-9 Retrieved from the Internet: URL:http://atomera.com/wp-content/uploads/ 2016/04/Effectivness_of_Quasi-Confinement_ Technology_for_Improving_P-Channel_Si_and_ Ge_MOSFET_Performance_IEEE_SNW_2013-1. pdf**

## Description

### Technical Field

The present disclosure generally relates to semiconductor devices and, more particularly, to CMOS structures and related circuits and methods.

### Background

Structures and techniques have been proposed to enhance the performance of semiconductor devices, such as by enhancing the mobility of the charge carriers. For example, U.S. Patent Application No. 2003/0057416 to Currie et al. discloses strained material layers of silicon, silicon-germanium, and relaxed silicon and also including impurity-free zones that would otherwise cause performance degradation. The resulting biaxial strain in the upper silicon layer alters the carrier mobilities enabling higher speed and/or lower power devices. Published U.S. Patent Application No. 2003/0034529 to Fitzgerald et al. discloses a CMOS inverter also based upon similar strained silicon technology.

U.S. Patent No. 6,472,685 B2 to Takagi discloses a semiconductor device including a silicon and carbon layer sandwiched between silicon layers so that the conduction band and valence band of the second silicon layer receive a tensile strain. Electrons having a smaller effective mass, and which have been induced by an electric field applied to the gate electrode, are confined in the second silicon layer, thus, an n-channel MOSFET is asserted to have a higher mobility.

U.S. Patent No. 4,937,204 to Ishibashi et al. discloses a superlattice in which a plurality of layers, less than eight monolayers, and containing a fractional or binary or a binary compound semiconductor layer, are alternately and epitaxially grown. The direction of main current flow is perpendicular to the layers of the superlattice.

U.S. Patent No. 5,357,119 to Wang et al. discloses a Si-Ge short period superlattice with higher mobility achieved by reducing alloy scattering in the superlattice. Along these lines, U.S. Patent No. 5,683,934 to Candelaria discloses an enhanced mobility MOSFET including a channel layer comprising an alloy of silicon and a second material substitutionally present in the silicon lattice at a percentage that places the channel layer under tensile stress.

U.S. Patent No. 5,216,262 to Tsu discloses a quantum well structure comprising two barrier regions and a thin epitaxially grown semiconductor layer sandwiched between the barriers. Each barrier region consists of alternate layers of $SiO_2$/Si with a thickness generally in a range of two to six monolayers. A much thicker section of silicon is sandwiched between the barriers.

An article entitled "Phenomena in silicon nanostructure devices" also to Tsu and published online September 6, 2000 by Applied Physics and Materials Science & Processing, pp. 391-402 discloses a semiconductor-atomic superlattice (SAS) of silicon and oxygen. The Si/O superlattice is disclosed as useful in a silicon quantum and light-emitting devices. In particular, a green electroluminescence diode structure was constructed and tested. Current flow in the diode structure is vertical, that is, perpendicular to the layers of the SAS. The disclosed SAS may include semiconductor layers separated by adsorbed species such as oxygen atoms, and CO molecules. The silicon growth beyond the adsorbed monolayer of oxygen is described as epitaxial with a fairly low defect density. One SAS structure included a 1.1 nm thick silicon portion that is about eight atomic layers of silicon, and another structure had twice this thickness of silicon. An article to Luo et al. entitled "Chemical Design of Direct-Gap Light-Emitting Silicon" published in Physical Review Letters, Vol. 89, No. 7 (August 12, 2002) further discusses the light emitting SAS structures of Tsu.

Published International Application WO 02/103,767 A1 to Wang, Tsu and Lofgren, discloses a barrier building block of thin silicon and oxygen, carbon, nitrogen, phosphorous, antimony, arsenic or hydrogen to thereby reduce current flowing vertically through the lattice more than four orders of magnitude. The insulating layer/barrier layer allows for low defect epitaxial silicon to be deposited next to the insulating layer.

Published Great Britain Patent Application 2,347,520 to Mears et al. discloses that principles of Aperiodic Photonic Band-Gap (APBG) structures may be adapted for electronic bandgap engineering. In particular, the application discloses that material parameters, for example, the location of band minima, effective mass, etc., can be tailored to yield new aperiodic materials with desirable band-structure characteristics. Other parameters, such as electrical conductivity, thermal conductivity and dielectric permittivity or magnetic permeability are disclosed as also possible to be designed into the material.

Furthermore, U.S. Pat. No. 6,376,337 to Wang et al. discloses a method for producing an insulating or barrier layer for semiconductor devices which includes depositing a layer of silicon and at least one additional element on the silicon substrate whereby the deposited layer is substantially free of defects such that epitaxial silicon substantially free of defects can be deposited on the deposited layer. Alternatively, a monolayer of one or more elements, preferably comprising oxygen, is absorbed on a silicon substrate. A plurality of insulating layers sandwiched between epitaxial silicon forms a barrier composite.

Document US 2016/088253 relates to an image sensor device in which a CMOS image sensor and an AD converter are stacked. EP 1 644 984 shows an image sensor having a strained SiGe channel. US 2015/008482 shows a transistor having a superlattice channel.

Despite the existence of such approaches, further enhancements may be desirable for using advanced semiconductor materials and processing techniques to achieve improved performance in semiconductor devices.

## Summary

A CMOS image sensor may include a first semiconductor chip including an array of image sensor pixels and readout circuitry electrically connected thereto, and a second semiconductor chip coupled to the first semiconductor chip in a stack and including image processing circuitry electrically connected to the readout circuitry. The readout circuitry may include a plurality of transistors each including spaced apart source and drain regions and a superlattice channel extending between the source and drain regions. The superlattice channel may include a plurality of stacked groups of layers, with each group of layers including a plurality of stacked base semiconductor monolayers defining a base semiconductor portion, and at least one non-semiconductor monolayer constrained within a crystal lattice of adjacent base semiconductor portions. Each transistor may further include a gate including a gate insulating layer on the superlattice channel and a gate electrode on the gate insulating layer.

More particularly, the first semiconductor chip may further include an electrical interconnect layer beneath the array of image sensor pixels and defining a back side illumination (BSI) configuration therewith, with the electrical interconnect layer electrically connecting the array of image sensor pixels with the readout circuitry. Moreover, the electrical interconnect layer may include a semiconductor layer and a plurality of spaced apart conductive traces within the semiconductor layer.

The CMOS image sensor may further include at least one lens overlying the array of image sensor pixels, as well as at least one color filter overlying the array of image sensor pixels. By way of example, the at least one color filter may comprise a respective color filter for each of the pixels in the array of image sensor pixels. Also by way of example, the at least one color filter may comprise a plurality of different color filters for filtering different respective wavelengths of light.

In an example implementation, the CMOS image sensor may further include a third semiconductor chip coupled with the first and second semiconductor chips in the stack and including a plurality of memory circuits. Furthermore, the image processing circuitry may also include a plurality of transistors each including a superlattice channel. By way of example, the at least one non-semiconductor monolayer may comprise oxygen, and the semiconductor monolayers may comprise silicon.

A method aspect is for making a CMOS image sensor and may include forming a first semiconductor chip including an array of image sensor pixels and readout circuitry electrically connected thereto, forming a second semiconductor chip comprising image processing circuitry electrically connected to the readout circuitry, and coupling the first semiconductor chip and the second semiconductor chip together in a stack. The readout circuitry may include a plurality of transistors each including, spaced apart source and drain regions, and a superlattice channel extending between the source and drain regions, the superlattice channel may include a plurality of stacked groups of layers, with each group of layers comprising a plurality of stacked base semiconductor monolayers defining a base semiconductor portion, and at least one non-semiconductor monolayer constrained within a crystal lattice of adjacent base semiconductor portions. Each transistor may also include a gate including a gate insulating layer on the superlattice channel and a gate electrode on the gate insulating layer.

More particularly, forming the first semiconductor chip may further include forming an electrical interconnect layer beneath the array of image sensor pixels and defining a back side illumination (BSI) configuration therewith, with the electrical interconnect layer electrically connecting the array of image sensor pixels with the readout circuitry. Moreover, forming the electrical interconnect layer may include forming a semiconductor layer and a plurality of spaced apart conductive traces within the semiconductor layer.

The method may further include positioning at least one lens overlying the array of image sensor pixels, as well as positioning at least one color filter overlying the array of image sensor pixels. By way of example, the at least one color filter may include a respective color filter for each of the pixels in the array of image sensor pixels. Furthermore, the at least one color filter may include a plurality of different color filters for filtering different respective wavelengths of light.

In accordance with one example, the method may also include forming a third semiconductor chip comprising a plurality of memory circuits, and coupling may further include coupling the third semiconductor chip with the first and second semiconductor chips in the stack. In an example embodiment, the image processing circuitry may also include a plurality of transistors each including a superlattice channel. By way of example, the at least one non-semiconductor monolayer may comprise oxygen, and the semiconductor monolayers may comprise silicon.

## Brief Description of the Drawings

FIG. 1 is a greatly enlarged schematic cross-sectional view of a superlattice for use in a semiconductor device in accordance with an example embodiment.

FIG. 2 is a perspective schematic atomic diagram of a portion of the superlattice shown in FIG. 1.

FIG. 3 is a greatly enlarged schematic cross-sectional view of another embodiment of a superlattice in accordance with an example embodiment.

FIG. 4A is a graph of the calculated band structure from the gamma point (G) for both bulk silicon as in the prior art, and for the 4/1 Si/O superlattice as shown in FIGS. 1-2.

FIG. 4B is a graph of the calculated band structure from the Z point for both bulk silicon as in the prior art, and for the 4/1 Si/O superlattice as shown in FIGS. 1-2.

FIG. 4C is a graph of the calculated band structure from both the gamma and Z points for both bulk silicon as in the prior art, and for the 5/1/3/1 Si/O superlattice as shown in FIG. 3.

FIG. 5 is an exploded perspective view of a CMOS image sensor device in accordance with an example embodiment including stacked semiconductor chips and readout circuitry including a superlattice.

FIG. 6 is an exploded perspective view of another CMOS image sensor device in accordance with an example embodiment including stacked semiconductor chips and image processing including a superlattice.

FIG. 7 is an exploded perspective view of still another CMOS image sensor device in accordance with an example embodiment including stacked semiconductor chips with a memory circuit chip and readout/image processing circuitry including a superlattice.

FIG. 8 is a cross-sectional diagram of a transistor including a superlattice channel which may be used in the circuits of the devices of FIGS. 5-7 in an example embodiment.

FIG. 9 is a cross-sectional diagram of an example CMOS image sensor pixel configuration which may be used in the devices of FIG. 5-7.

FIGS. 10 and 11 are graphs of simulated yield Iw vs. yield SNM, respectively, for a prior art transistor configuration and a transistor with a superlattice channel providing a super steep retrograde profile in accordance with an example embodiment.

## Detailed Description

Example embodiments will now be described more fully hereinafter with reference to the accompanying drawings, in which the example embodiments are shown. The embodiments may, however, be implemented in many different forms and should not be construed as limited to the specific examples set forth herein. Rather, these embodiments are provided so that this disclosure will be thorough and complete. Like numbers refer to like elements throughout, and prime and multiple prime notation are used to indicate similar elements in different embodiments.

Generally speaking, the present disclosure relates to CMOS image sensor (CIS) devices having an enhanced semiconductor superlattice therein which may provide desired speed enhancement and thermal management features. The enhanced semiconductor superlattice is also referred to as an "MST" layer or "MST technology" in this disclosure and the accompanying drawings.

More particularly, the MST technology relates to advanced semiconductor materials such as the superlattice **25** described further below. Applicant theorizes, without wishing to be bound thereto, that certain superlattices as described herein reduce the effective mass of charge carriers and that this thereby leads to higher charge carrier mobility. Effective mass is described with various definitions in the literature. As a measure of the improvement in effective mass Applicant's use a "conductivity reciprocal effective mass tensor", $\mathbf{M}_e^{-1}$ and $\mathbf{M}_h^{-1}$ for electrons and holes respectively, defined as:

$$\mathbf{M}_{e,ij}^{-1}(E_F,T) = \frac{\sum_{E>E_F}\int_{B.Z.}\left(\nabla_{\mathbf{k}}E(\mathbf{k},n)\right)_i\left(\nabla_{\mathbf{k}}E(\mathbf{k},n)\right)_j\frac{\partial f(E(\mathbf{k},n),E_F,T)}{\partial E}d^3\mathbf{k}}{\sum_{E>E_F}\int_{B.Z.}f(E(\mathbf{k},n),E_F,T)d^3\mathbf{k}}$$

for electrons and:

$$\mathbf{M}_{h,ij}^{-1}(E_F,T) = \frac{-\sum_{E<E_F}\int_{B.Z.}\left(\nabla_{\mathbf{k}}E(\mathbf{k},n)\right)_i\left(\nabla_{\mathbf{k}}E(\mathbf{k},n)\right)_j\frac{\partial f(E(\mathbf{k},n),E_F,T)}{\partial E}d^3\mathbf{k}}{\sum_{E<E_F}\int_{B.Z.}(1-f(E(\mathbf{k},n),E_F,T))d^3\mathbf{k}}$$

for holes, where $f$ is the Fermi-Dirac distribution, $E_F$ is the Fermi energy, T is the temperature, E(k,n) is the energy of an electron in the state corresponding to wave vector k and the $n^{th}$ energy band, the indices i and j refer to Cartesian coordinates x, y and z, the integrals are taken over the Brillouin zone (B.Z.), and the summations are taken over bands with energies above and below the Fermi energy for electrons and holes respectively.

Applicant's definition of the conductivity reciprocal effective mass tensor is such that a tensorial component of the conductivity of the material is greater for greater values of the corresponding component of the conductivity reciprocal effective mass tensor. Again Applicant theorizes without wishing to be bound thereto that the superlattices described herein set the values of the conductivity reciprocal effective mass tensor so as to enhance the conductive properties of the material, such as typically for a preferred direction of charge carrier transport. The inverse of the appropriate tensor element is referred to as the conductivity effective mass. In other words, to characterize semiconductor material structures, the conductivity effective mass for electrons/holes as described above and calculated in the direction of intended carrier transport is used to distinguish improved materials.

Applicant has identified improved materials or structures for use in semiconductor devices. More specifically, Applicant has identified materials or structures having energy band structures for which the appropriate conductivity effective masses for electrons and/or holes are substantially less than the corresponding values for silicon. In addition to the enhanced mobility characteristics of these structures, they may also be formed or used in such a manner that they provide piezoelectric, pyroelectric, and/or ferroelectric properties that are advantageous for use in a variety of different types of devices, as will be discussed further below.

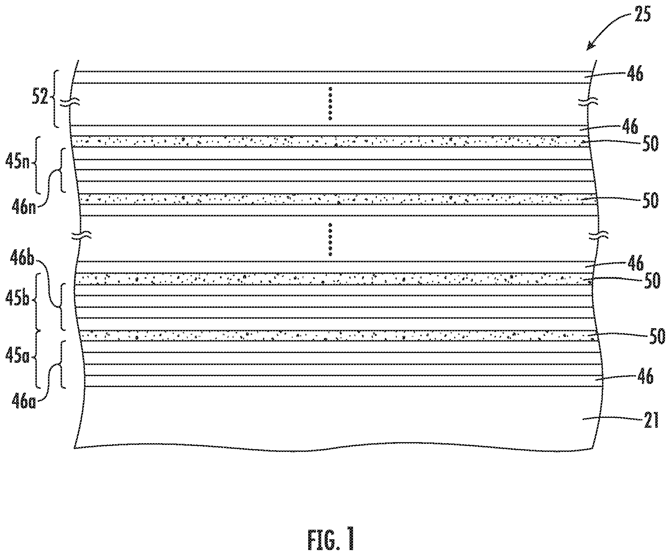

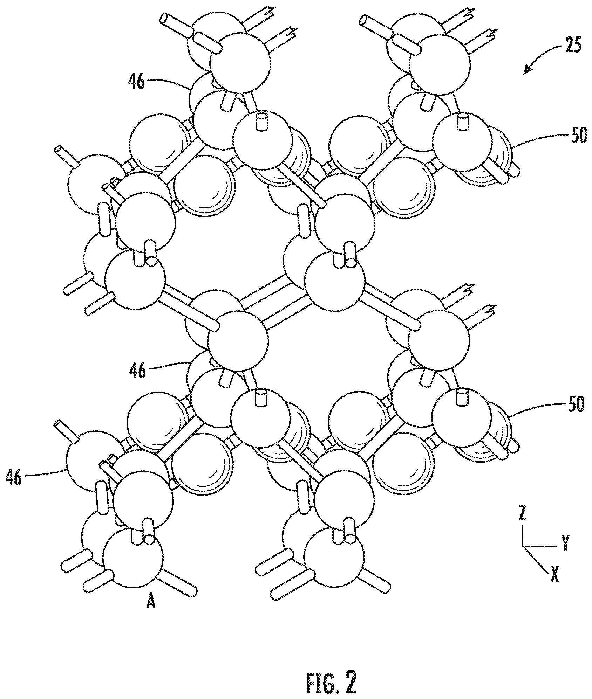

Referring now to FIGS. 1 and 2, the materials or structures are in the form of a superlattice 25 whose structure is controlled at the atomic or molecular level and may be formed using known techniques of atomic or molecular layer deposition. The superlattice 25 includes a plurality of layer groups 45a-45n arranged in stacked relation, as perhaps best understood with specific reference to the schematic cross-sectional view of FIG. 1.

Each group of layers 45a-45n of the superlattice 25 illustratively includes a plurality of stacked base semiconductor monolayers 46 defining a respective base semiconductor portion 46a-46n and an energy band-modifying layer 50 thereon. The energy band-modifying layers 50 are indicated by stippling in FIG. 1 for clarity of illustration.

The energy band-modifying layer 50 illustratively includes one non-semiconductor monolayer constrained within a crystal lattice of adjacent base semiconductor portions. By "constrained within a crystal lattice of adjacent base semiconductor portions" it is meant that at least some semiconductor atoms from opposing base semiconductor portions 46a-46n are chemically bound together through the non-semiconductor monolayer 50 therebetween, as seen in FIG. 2. Generally speaking, this configuration is made possible by controlling the amount of non-semiconductor material that is deposited on semiconductor portions 46a-46n through atomic layer deposition techniques so that not all (i.e., less than full or 100% coverage) of the available semiconductor bonding sites are populated with bonds to non-semiconductor atoms, as will be discussed further below. Thus, as further monolayers 46 of semiconductor material are deposited on or over a non-semiconductor monolayer 50, the newly deposited semiconductor atoms will populate the remaining vacant bonding sites of the semiconductor atoms below the non-semiconductor monolayer.

In other embodiments, more than one such non-semiconductor monolayer may be possible. It should be noted that reference herein to a non-semiconductor or semiconductor monolayer means that the material used for the monolayer would be a non-semiconductor or semiconductor if formed in bulk. That is, a single monolayer of a material, such as silicon, may not necessarily exhibit the same properties that it would if formed in bulk or in a relatively thick layer, as will be appreciated by those skilled in the art.

Applicant theorizes without wishing to be bound thereto that energy band-modifying layers 50 and adjacent base semiconductor portions 46a-46n cause the superlattice 25 to have a lower appropriate conductivity effective mass for the charge carriers in the parallel layer direction than would otherwise be present. Considered another way, this parallel direction is orthogonal to the stacking direction. The band modifying layers 50 may also cause the superlattice 25 to have a common energy band structure, while also advantageously functioning as an insulator between layers or regions vertically above and below the superlattice.

Moreover, this superlattice structure may also advantageously act as a barrier to dopant and/or material diffusion between layers vertically above and below the superlattice 25. These properties may thus advantageously allow the superlattice 25 to provide an interface for high-K dielectrics which not only reduces diffusion of the high-K material into the channel region, but which may also advantageously reduce unwanted scattering effects and improve device mobility, as will be appreciated by those skilled in the art.

It is also theorized that semiconductor devices including the superlattice **25** may enjoy a higher charge carrier mobility based upon the lower conductivity effective mass than would otherwise be present. In some embodiments, and as a result of the band engineering achieved by the present invention, the superlattice **25** may further have a substantially direct energy bandgap that may be particularly advantageous for opto-electronic devices, for example.

The superlattice **25** also illustratively includes a cap layer **52** on an upper layer group **45n**. The cap layer **52** may comprise a plurality of base semiconductor monolayers **46**. The cap layer **52** may have between 2 to 100 monolayers of the base semiconductor, and, more preferably between 10 to 50 monolayers.

Each base semiconductor portion **46a-46n** may comprise a base semiconductor selected from the group consisting of Group IV semiconductors, Group III-V semiconductors, and Group II-VI semiconductors. Of course, the term Group IV semiconductors also includes Group IV-IV semiconductors, as will be appreciated by those skilled in the art. More particularly, the base semiconductor may comprise at least one of silicon and germanium, for example.

Each energy band-modifying layer **50** may comprise a non-semiconductor selected from the group consisting of oxygen, nitrogen, fluorine, carbon and carbon-oxygen, for example. The non-semiconductor is also desirably thermally stable through deposition of a next layer to thereby facilitate manufacturing. In other embodiments, the non-semiconductor may be another inorganic or organic element or compound that is compatible with the given semiconductor processing as will be appreciated by those skilled in the art. More particularly, the base semiconductor may comprise at least one of silicon and germanium, for example

It should be noted that the term monolayer is meant to include a single atomic layer and also a single molecular layer. It is also noted that the energy band-modifying layer **50** provided by a single monolayer is also meant to include a monolayer wherein not all of the possible sites are occupied (i.e., there is less than full or 100% coverage). For example, with particular reference to the atomic diagram of FIG. 2, a 4/1 repeating structure is illustrated for silicon as the base semiconductor material, and oxygen as the energy band-modifying material. Only half of the possible sites for oxygen are occupied in the illustrated example.

In other embodiments and/or with different materials this one-half occupation would not necessarily be the case as will be appreciated by those skilled in the art. Indeed it can be seen even in this schematic diagram, that individual atoms of oxygen in a given monolayer are not precisely aligned along a flat plane as will also be appreciated by those of skill in the art of atomic deposition. By way of example, a preferred occupation range is from about one-eighth to one-half of the possible oxygen sites being full, although other numbers may be used in certain embodiments.

Silicon and oxygen are currently widely used in conventional semiconductor processing, and, hence, manufacturers will be readily able to use these materials as described herein. Atomic or monolayer deposition is also now widely used. Accordingly, semiconductor devices incorporating the superlattice **25** in accordance with the invention may be readily adopted and implemented, as will be appreciated by those skilled in the art.

It is theorized without Applicant wishing to be bound thereto that for a superlattice, such as the Si/O superlattice, for example, that the number of silicon monolayers should desirably be seven or less so that the energy band of the superlattice is common or relatively uniform throughout to achieve the desired advantages. The 4/1 repeating structure shown in FIGS. 1 and 2, for Si/O has been modeled to indicate an enhanced mobility for electrons and holes in the X direction. For example, the calculated conductivity effective mass for electrons (isotropic for bulk silicon) is 0.26 and for the 4/1 SiO superlattice in the X direction it is 0.12 resulting in a ratio of 0.46. Similarly, the calculation for holes yields values of 0.36 for bulk silicon and 0.16 for the 4/1 Si/O superlattice resulting in a ratio of 0.44.

While such a directionally preferential feature may be desired in certain semiconductor devices, other devices may benefit from a more uniform increase in mobility in any direction parallel to the groups of layers. It may also be beneficial to have an increased mobility for both electrons and holes, or just one of these types of charge carriers as will be appreciated by those skilled in the art.

The lower conductivity effective mass for the 4/1 Si/O embodiment of the superlattice **25** may be less than two-thirds the conductivity effective mass than would otherwise occur, and this applies for both electrons and holes. Of course, the superlattice **25** may further comprise at least one type of conductivity dopant therein, as will also be appreciated by those skilled in the art.

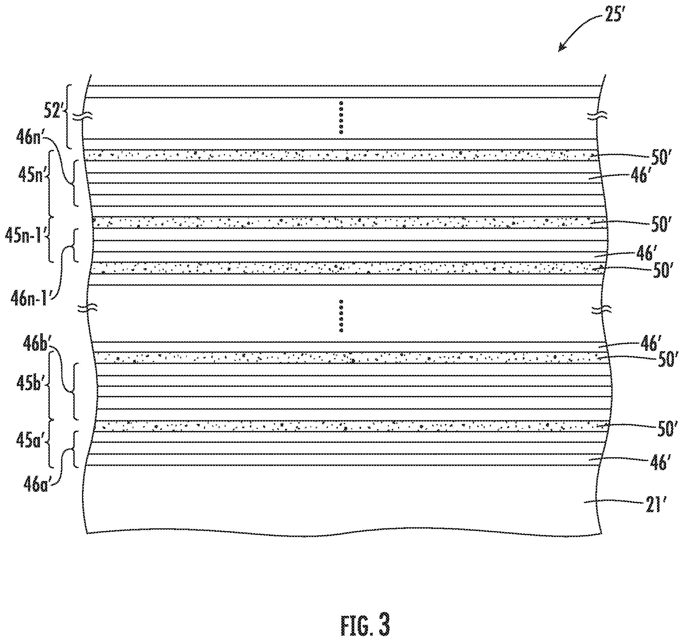

Indeed, referring now additionally to FIG. 3, another embodiment of a superlattice **25'** in accordance with the invention having different properties is now described. In this embodiment, a repeating pattern of 3/1/5/1 is illustrated. More particularly, the lowest base semiconductor portion **46a'** has three monolayers, and the second lowest base semiconductor portion **46b'** has five monolayers. This pattern repeats throughout the superlattice **25'**. The energy band-modifying layers **50'** may each include a single monolayer. For such a superlattice **25'** including Si/O, the enhancement of charge carrier mobility is independent of orientation in the plane of the layers. Those other elements of FIG. 3 not specifically mentioned are similar to those discussed above with reference to FIG. 1 and need no further discussion herein.

In some device embodiments, all of the base semiconductor portions of a superlattice may be a same number of monolayers thick. In other embodiments, at least some of the base semiconductor portions may be a different number of monolayers thick. In still other embodiments, all of the base semiconductor portions may be a different number of monolayers thick.

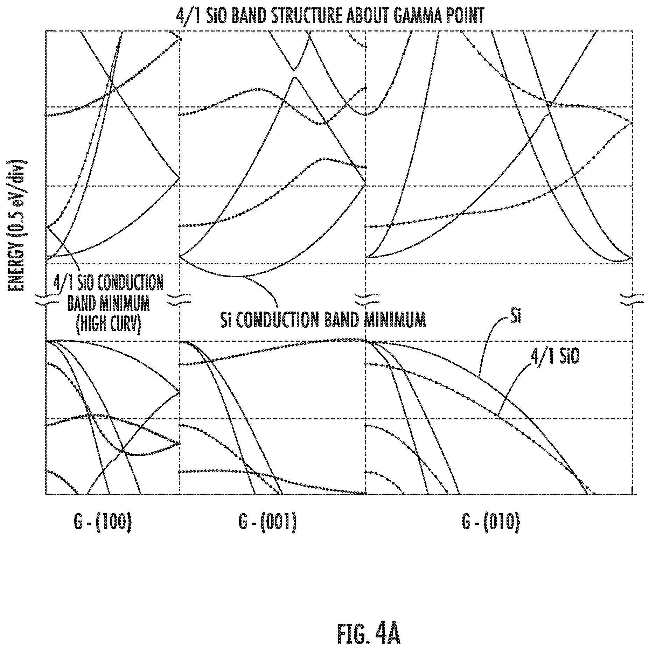

In FIGS. 4A-4C, band structures calculated using Density Functional Theory (DFT) are presented. It is well known in the art that DFT underestimates the absolute value of the bandgap. Hence all bands above the gap may be shifted by an appropriate "scissors correction." However the shape of the band is known to be much more reliable. The vertical energy axes should be interpreted in this light.

FIG. 4A shows the calculated band structure from the gamma point (G) for both bulk silicon (represented by continuous lines) and for the 4/1 Si/O superlattice **25** shown in FIG. 1 (represented by dotted lines). The directions refer to the unit cell of the 4/1 Si/O structure and not to the conventional unit cell of Si, although the (001) direction in the figure does correspond to the (001) direction of the conventional unit cell of Si, and, hence, shows the expected location of the Si conduction band minimum. The (100) and (010) directions in the figure correspond to the (110) and (-110) directions of the conventional Si unit cell. Those skilled in the art will appreciate that the bands of Si on the figure are folded to represent them on the appropriate reciprocal lattice directions for the 4/1 Si/O structure.

It can be seen that the conduction band minimum for the 4/1 Si/O structure is located at the gamma point in contrast to bulk silicon (Si), whereas the valence band minimum occurs at the edge of the Brillouin zone in the (001) direction which we refer to as the Z point. One may also note the greater curvature of the conduction band minimum for the 4/1 Si/O structure compared to the curvature of the conduction band minimum for Si owing to the band splitting due to the perturbation introduced by the additional oxygen layer.

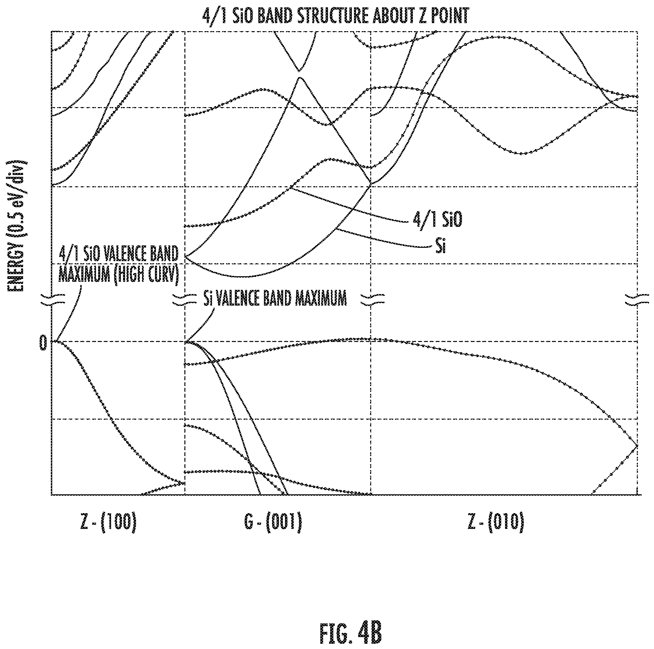

FIG. 4B shows the calculated band structure from the Z point for both bulk silicon (continuous lines) and for the 4/1 Si/O superlattice **25** (dotted lines). This figure illustrates the enhanced curvature of the valence band in the (100) direction.

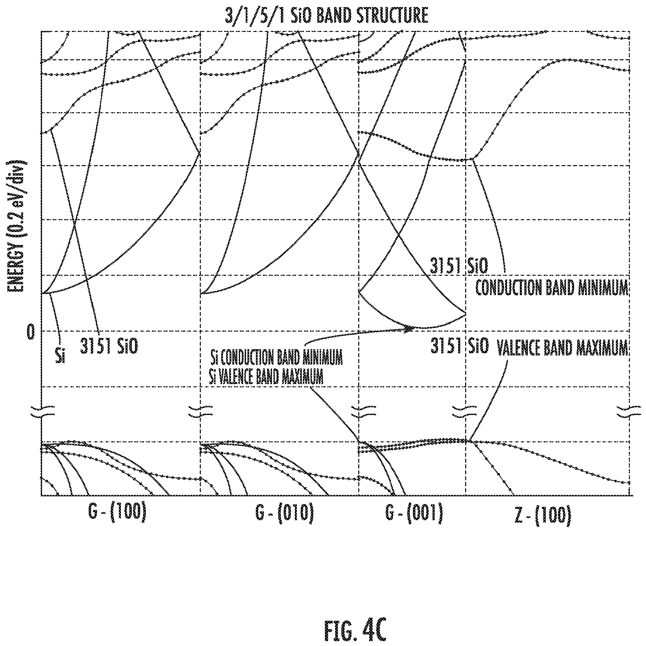

FIG. 4C shows the calculated band structure from both the gamma and Z point for both bulk silicon (continuous lines) and for the 5/1/3/1 Si/O structure of the superlattice **25'** of FIG. 3 (dotted lines). Due to the symmetry of the 5/1/3/1 Si/O structure, the calculated band structures in the (100) and (010) directions are equivalent. Thus the conductivity effective mass and mobility are expected to be isotropic in the plane parallel to the layers, i.e. perpendicular to the (001) stacking direction. Note that in the 5/1/3/1 Si/O example the conduction band minimum and the valence band maximum are both at or close to the Z point.

Although increased curvature is an indication of reduced effective mass, the appropriate comparison and discrimination may be made via the conductivity reciprocal effective mass tensor calculation. This leads Applicant to further theorize that the 5/1/3/1 superlattice **25'** should be substantially direct bandgap. As will be understood by those skilled in the art, the appropriate matrix element for optical transition is another indicator of the distinction between direct and indirect bandgap behavior.

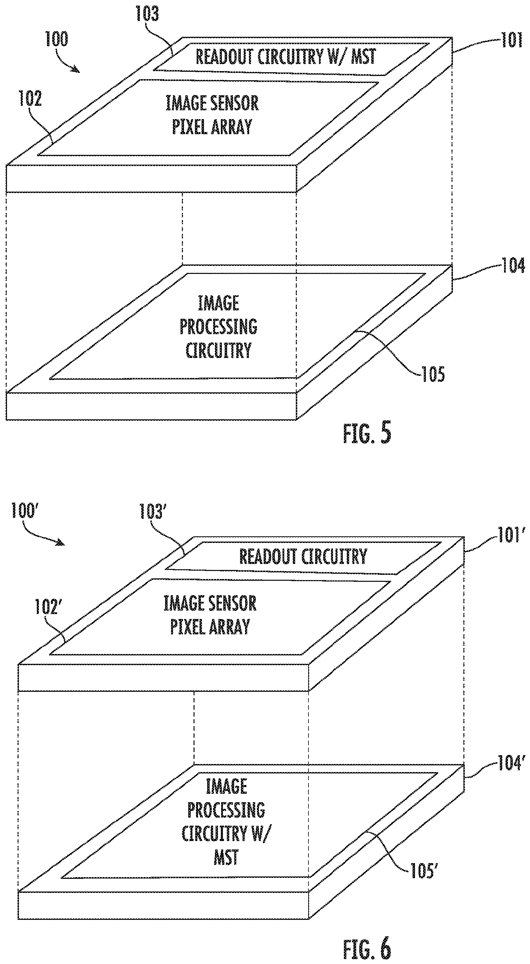

Referring now to FIG. 5, the above described superlattice structures may advantageously be used in a CMOS image sensor **100**. The image sensor **100** illustratively includes a first semiconductor chip **101** which in turn includes an array of image sensor pixels **102** and readout circuitry **103** electrically connected thereto. The sensor **100** further illustratively includes a second semiconductor chip **104** coupled to the first semiconductor chip **101** in a stack and including image processing circuitry 105 electrically connected to the readout circuitry.

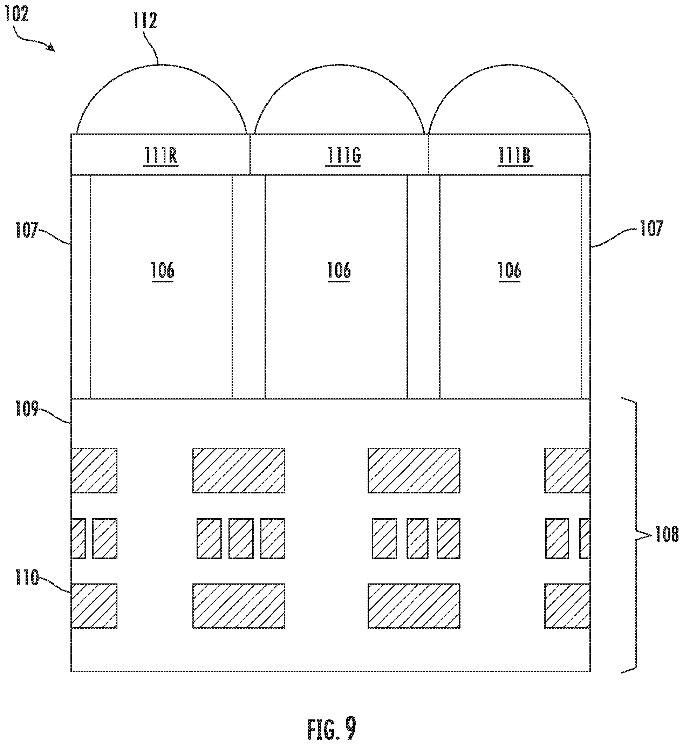

An example pixel cell architecture which may be used for the image sensor pixel array **102** is shown in FIG. 9. In the illustrated example, the array **102** is a back side illumination (BSI) configuration which illustratively includes a plurality of photodiodes **106** with insulating regions **107** therebetween. Furthermore, an electrical interconnect layer **108** is beneath the array of image sensor pixels **102** in the illustrated BSI configuration (although the stacked chip CIS arrangements described herein may be used with front side illumination (FSI) configurations as well). The electrical interconnect layer **108** illustratively includes a semiconductor layer **109** (e.g., polysilicon) and a plurality of spaced apart conductive traces **110** electrically connecting the array of image sensor pixels **102** with the readout circuitry **103**. By way of example, the array **102** may include CMOS active pixel sensors with pinned photodiodes **106** and associated control/output circuitry (e.g., a 4T cell).

Furthermore, a respective red, green, or blue color filter **111R**, **111G,** or **111B** may be positioned above each of the photodiodes **106,** as well as a respective micro-lens **112** overlying each of the color filters. The lenses **112** may be used to advantageously gather and direct light to each of the photodiodes **106**. The signal detected by each photodiode **106** may be individually read out by a row and column selector, followed by amplification circuitry (not shown) and the readout circuitry **103** to provide the signals to the image processing circuitry **105.**

Generally speaking, BSI implementations may be desirable over front side illumination (FSI) configurations for a variety of reasons. First, BSI sensors typically have higher light sensitivity and higher quantum efficiency (QE) or approximately 70-80%. Moreover, in BSI sensors the electrical interconnect layer **108** is out of the optical path, which allows for a thinner substrate and results in less optical crosstalk. Furthermore, BSI configurations allow for a wider chief ray angle (CRA), which enables large aperture lenses and thinner modules.

Nevertheless, in a typical BSI CIS integration the pixel transistors and image processing circuits are fabricated on separate wafers (i.e., the first and second semiconductor chips **101, 104)** using different process technologies. Generally speaking, more advanced technologies are used for fabricating the image processing circuitry **105** on the second chip **104.** For example, two different technology nodes may be used, such as 40nm for the second semiconductor wafer **105** and 65nm or 90nm for the first semiconductor chip **101.** While this may provide for processing and cost savings with respect to the first semiconductor chip **101,** use of the different nodes may cause transistor performance mismatches to occur between the readout circuitry **103** and the more advanced, high-speed image processing circuitry **105.** This, in turn, may degrade product performance.

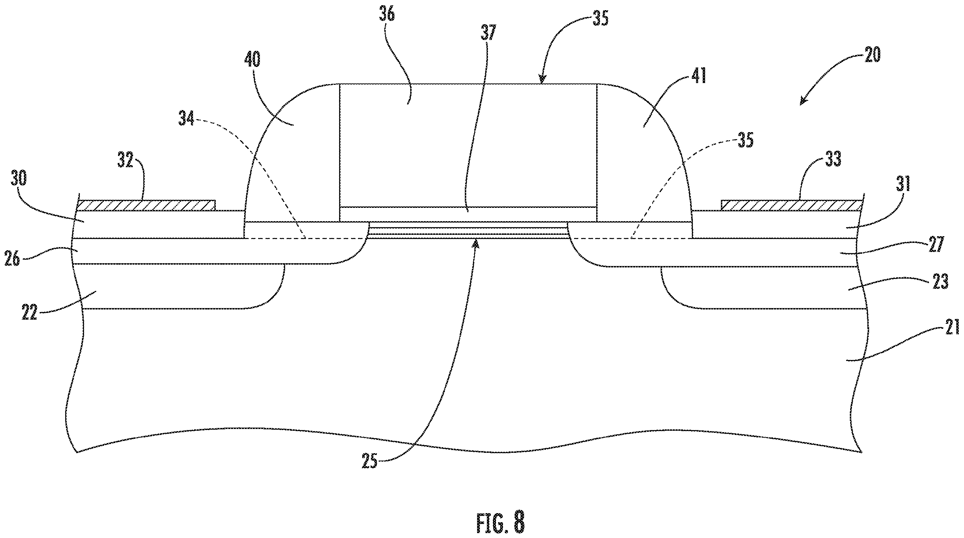

In accordance with an example implementation, the readout circuitry 103 may advantageously include a plurality of transistors (MOSFETs) **20** (FIG. 8) including the above-described band-engineered superlattice **25.** More particularly, the MOSFET **20** illustratively includes a substrate **21,** source/drain regions **22, 23,** source/drain extensions **26, 27,** and a channel region therebetween provided by the superlattice **25.** Source/drain silicide layers **30, 31** and source/drain contacts **32, 33** overlie the source/drain regions, as will be appreciated by those skilled in the art. Regions indicated by dashed lines **34, 35** are optional vestigial portions formed originally with the superlattice material, but thereafter heavily doped. In other embodiments, these vestigial superlattice regions **34, 35** may not be present as will also be appreciated by those skilled in the art.

A gate **38** illustratively includes a gate insulating layer **37** adjacent the channel provided by the superlattice **25,** and a gate electrode layer **36** on the gate insulating layer. Sidewall spacers **40, 41** are also provided in the illustrated MOSFET **20.** It should be noted that other transistor configurations including the above-described superlattice material may also be used in different embodiments for the readout circuitry **103** in addition to the planar MOSFET **20** shown. Moreover, some portion of the channel may also be defined in the substrate **21** in certain implementations. Further details on the MOSFET **20** may be found in U.S. Pat. No. 6,897,472 to Mears et al., which is assigned to the present Applicant and hereby incorporate herein in its entirety by reference.

In particular, as described above the band-engineered MST material advantageously helps enhance charge carrier flow and thereby increase circuit speed, and thus total product performance, which helps alleviate the above-described mismatch between the readout circuitry **103** and the image processing circuitry **105.** Moreover, use of the MST superlattice material also provides for a significant Vt variability improvement in the readout circuitry **103** transistors, as will be discussed further below, which may also advantageously help reduce fixed pattern noise in the image sensor **100** as well. By way of example, the superlattice channels **25** in the transistors **20** of the readout circuitry may be formed using selective epitaxy at the appropriate locations, or by blanket deposition followed by patterning of the blanket superlattice layer.

By way of reference, as an example of the speed enhancements which may be achieved using transistors with MST channels in logic circuits, simulations of various logic circuit configurations with and without MST-enabled transistors were performed. The first logic circuit was an inverter, and the simulations showed that the MST-enabled invertor had an approximate 20% decrease in leakage with a 15% increase in speed and comparable power consumption. Further, NAND logic gates with and without MST-enabled transistors were also simulated, and the MST-enabled gate had approximately 10% lower leakage with an approximate 20% increase in speed and a 5% lower power consumption. For the simulations, a 4/1 repeating MST material was used for the channel layer (as seen in FIG. 1).

In the typical BSI process flow, photodiode **106** implantation may first be performed in a silicon substrate or layer, followed by the poly/metal deposition for the electrical interconnect layer **108.** Thereafter, the wafer may be flipped over and bonded to a silicon handle. Backside grinding may then be performed to reveal the photodiodes **106,** and the color filters **111R, 111G, 111B** and micro-lenses **112** may be provided thereafter to complete the image sensor pixel array **102.**

Referring now additionally FIG. 6, another example embodiment of the image sensor **100'** illustratively includes image processing circuitry **105'** which has one or more sections which also include transistors (such as the transistor **20** of FIG. 8) having a superlattice channel. That is, in this example the MST material is used in the image processing circuitry **105'** of the second semiconductor chip **104'** rather than in the readout circuitry **103'** of the first semiconductor chip **101'** (although it may be used in both in some embodiments, as will be discussed further below). By way of example, the image processing circuitry **105'** may include a plurality of counters, and the transistors **20** may be used to define the counters, although they may be used in other areas of the image processing circuitry as well (e.g., logic/processing circuitry, etc.).

By way of background, temporal noise due to thermal noise is an important characteristic for CIS devices. One approach for reducing thermal noise is to reduce heat dissipation using low-power circuits with low-voltage operation. More particularly, use of the MST material to provide super steep retrograde (SSR) channel formation as a result of its inherent dopant diffusion blocking effect may advantageously be leveraged to improve Vt variability and allow lower voltage operation. Further details regarding the use of the MST material to provide desired SSR profiles are provided in U.S. Pat. Pub. Nos. 2016/0336406 and 2016/0336407 to Mears et al., which are also assigned to the present Applicant and are hereby incorporated herein in their entireties by reference.

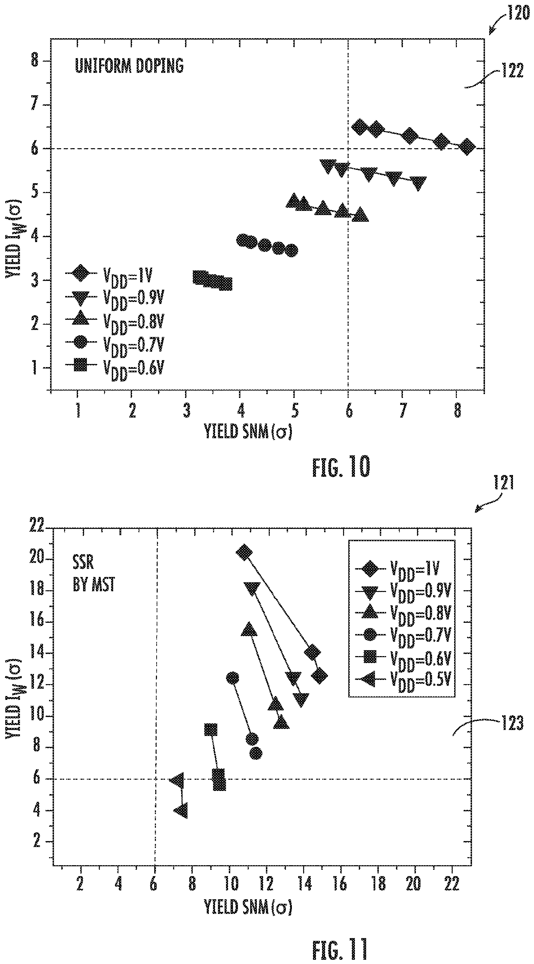

Turning now to FIGS. 10 and 11, a comparison is provided between 6T-SRAM yield for uniform doping (graph **120)** and an SSR channel resulting from an MST film (graph **121)** as simulated by a TCAD modelling. More particularly, the change in a functional window **122** of the graph **120** to the functional window **123** of the graph **121** demonstrates that the SSR achieved by the MST film may advantageously reduce Vdd from 1V to 0.5V, and thereby reduce heat for lower thermal noise.

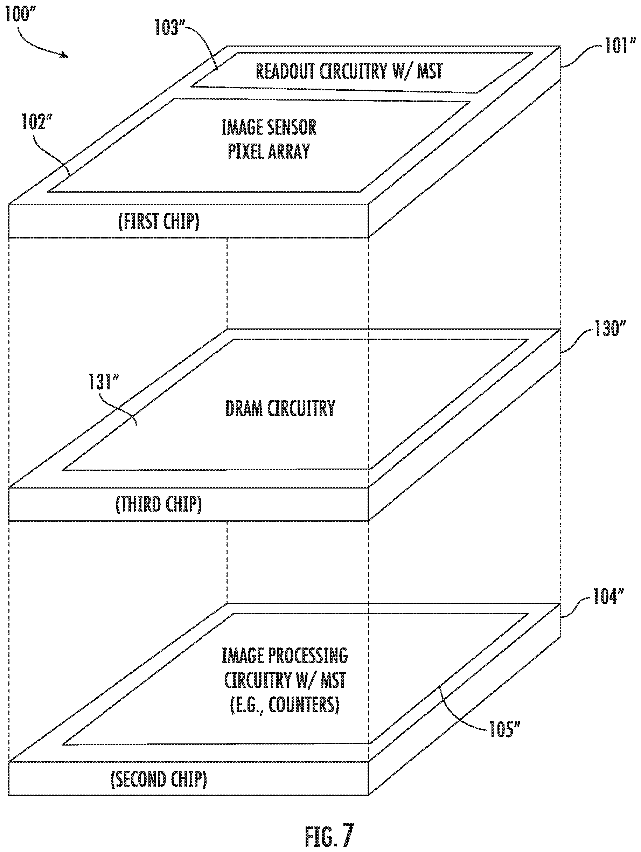

Referring additionally to FIG. 7, another example implementation of the CMOS image sensor **100"** illustratively includes a third semiconductor chip **130"** coupled with the first and second semiconductor chips **101", 104"** in the stack (i.e., in between them). Here, the third chip **130"** illustratively includes a plurality of memory circuits, which in the present example includes DRAM circuitry **131".** Furthermore, in this example, both the readout circuitry **103"** and the image processing circuitry **105"** include transistors with the MST superlattice film to provide the above-noted operational advantages.

A method for making the CMOS image sensor **100** may include forming the first semiconductor chip **101** including the array of image sensor pixels **102** and readout circuitry **103** electrically connected thereto, and forming the second semiconductor chip **104** including image processing circuitry **105** electrically connected to the readout circuitry. The method may further include coupling the first semiconductor chip **101** and the second semiconductor chip **104** together in a stack as shown in FIG. 5. The readout circuitry **103** may include a plurality of transistors (such as the MOSFET **20)** including a superlattice channel **25** as described further above.

A related method for making the CMOS image sensor **100'** may include forming the first semiconductor chip **101'** including the array of image sensor pixels **102'** and readout circuitry **103'** electrically connected thereto, and forming the second semiconductor chip **104'** including image processing circuitry **105'** electrically connected to the readout circuitry. The method may further include coupling the first semiconductor chip **101'** and the second semiconductor chip **104'** in a stack as shown in FIG. 6. The processing circuitry **105'** may include a plurality of transistors (such as the MOSFET **20)** each including a superlattice channel **25** as discussed further above.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

**Claims**

1. A CMOS image sensor (100, 100', 100") comprising:

   a first semiconductor chip (101, 101', 101") comprising an array of image sensor pixels (102, 102', 102") and readout circuitry (103, 103', 103") electrically connected thereto; and
   a second semiconductor chip (104, 104', 104") coupled to the first semiconductor chip in a stack and comprising image processing circuitry electrically connected to the readout circuitry;
   **characterised in that**
   the readout circuitry comprises a plurality of transistors (20) each comprising

   spaced apart source and drain regions (22, 23),
   a superlattice channel (25) extending between the source and drain regions, the superlattice channel comprising a plurality of stacked groups of layers (45a-45n), each group of layers comprising a plurality of stacked base semiconductor monolayers (46) defining a base semiconductor portion (46a-46n), and at least one non-semiconductor monolayer (50) constrained within a crystal lattice of adjacent base semiconductor portions, and
   a gate (38) comprising a gate insulating layer (37) on the superlattice channel and a gate electrode (36) on the gate insulating layer.

2. The CMOS image sensor of Claim 1 wherein the first semiconductor chip further comprises an electrical interconnect layer (108) beneath the array of image sensor pixels and defining a back side illumination (BSI) configuration therewith, the electrical interconnect layer electrically connecting the array of image sensor pixels with the readout circuitry.

3. The CMOS image sensor of Claim 2 wherein the electrical interconnect layer comprises a semiconductor layer (109) and a plurality of spaced apart conductive traces (110) within the semiconductor layer.

4. The CMOS image sensor of Claim 1 further comprising at least one lens (112) overlying the array of image sensor pixels.

5. The CMOS image sensor of Claim 1 further comprising at least one color filter (11R, 111G,111B) overlying the array of image sensor pixels.

6. The CMOS image sensor of Claim 5 wherein the at least one color filter comprises a respective color filter for each of the pixels in the array of image sensor pixels.

7. The CMOS image sensor of Claim 5 wherein the at least one color filter comprises a plurality of different color filters for filtering different respective wavelengths of light.

8. The CMOS image sensor of Claim 1 further comprising a third semiconductor chip (130") coupled with the first and second semiconductor chips in the stack and comprising a plurality of memory circuits.

9. The CMOS image sensor of Claim 1 wherein the image processing circuitry also comprises a plurality of transistors each including a superlattice channel.

10. The CMOS image sensor of Claim 1 wherein the at least one non-semiconductor monolayer comprises oxygen and the semiconductor monolayers comprise silicon.

11. A method for making a CMOS image sensor (100, 100', 100") as defined in claim 1, the method comprising:

> forming a first semiconductor chip (101, 101', 101") comprising an array of image sensor pixels (102, 102', 102") and readout circuitry (103, 103', 103") electrically connected thereto;
> forming a second semiconductor chip (104, 104', 104") comprising image processing circuitry electrically connected to the readout circuitry; and
> coupling the first semiconductor chip and the second semiconductor chip together in a stack;
> the readout circuitry comprising a plurality of transistors (20) each comprising

>> spaced apart source and drain regions (22, 23),
>> a superlattice channel (25) extending between the source and drain regions, the superlattice channel comprising a plurality of stacked groups of layers (45a-45n), each group of layers comprising a plurality of stacked base semiconductor monolayers (46) defining a base semiconductor portion (46a-46n), and at least one non-semiconductor monolayer (50) constrained within a crystal lattice of adjacent base semiconductor portions, and
>> a gate (38) comprising a gate insulating layer (37) on the superlattice channel and a gate electrode (36) on the gate insulating layer.

12. The method of Claim 11 wherein forming the first semiconductor chip further comprises forming an electrical interconnect layer (108) beneath the array of image sensor pixels and defining a back side illumination (BSI) configuration therewith, the electrical interconnect layer electrically connecting the array of image sensor pixels with the readout circuitry.

13. The method of Claim 12 wherein forming the electrical interconnect layer comprises forming a semiconductor layer (109) and a plurality of spaced apart conductive traces (110) within the semiconductor layer.

14. The method of Claim 11 further comprising positioning at least one lens (112) overlying the array of image sensor pixels.

15. The method of Claim 11 further comprising positioning at least one color filter (11R, 111G,111B) overlying the array of image sensor pixels.

**Patentansprüche**

1. CMOS-Bildsensor (100, 100', 100"), aufweisend:

> einen ersten Halbleiterchip (101, 101', 101") mit einem Array von Bildsensorpixeln (102, 102', 102") und einer damit elektrisch verbundenen Ausleseschaltung (103, 103', 103"); und
> einen zweiten Halbleiterchip (104, 104, 104"), der an den ersten Halbleiterchip in einem Stapel gekoppelt ist und eine mit der Ausleseschaltung elektrisch verbundene Bildverarbeitungsschaltung aufweist;
> **dadurch gekennzeichnet, dass**
> die Ausleseschaltung mehrere Transistoren (20) aufweist, die jeweils aufweisen:

beabstandete Source- und Drain-Bereiche (22, 23),
einen Übergitterkanal (25), der zwischen den Source- und Drain-Bereichen verläuft, wobei der Übergitterkanal mehrere Stapelgruppen von Schichten (45a-45n) aufweist, wobei jede Gruppe von Schichten mehrere gestapelte Basishalbleiter-Monoschichten (46), die einen Basishalbleiterabschnitt (46a-46n) definieren, und wenigstens eine Nicht-Halbleiter-Monoschicht (50), die in einem Kristallgitter von benachbarten Basishalbleiterabschnitten eingezwängt ist, aufweist, und
ein Gate (38) mit einer Gate-Isolierschicht (37) auf dem Übergitterkanal und einer Gate-Elektrode (36) auf der Gate-Isolierschicht.

2.  CMOS-Bildsensor nach Anspruch 1, bei welchem der erste Halbleiterchip ferner eine elektrische Verbindungsschicht (108) unter dem Array von Bildsensorpixeln aufweist und damit eine Rückseitenbeleuchtungs- (BSI-) Konfiguration definiert, wobei die elektrische Verbindungsschicht das Array von Bildsensorpixeln mit der Ausleseschaltung elektrisch verbindet.

3.  CMOS-Bildsensor nach Anspruch 2, bei welchem die elektrische Verbindungsschicht eine Halbleiterschicht (109) und mehrere beabstandeten Leiterspuren (110) in der Halbleiterschicht aufweist.

4.  CMOS-Bildsensor nach Anspruch 1, ferner aufweisend wenigstens eine Linse (112), die über dem Array von Bildsensorpixeln liegt.

5.  CMOS-Bildsensor nach Anspruch 1, ferner aufweisend wenigstens einen Farbfilter (111R, 111G, 111b), der über dem Array von Bildsensorpixeln liegt.

6.  CMOS-Bildsensor nach Anspruch 5, bei welchem der wenigstens eine Farbfilter einen jeweiligen Farbfilter für jedes der Pixel im Array von Bildsensorpixeln aufweist.

7.  CMOS-Bildsensor nach Anspruch 5, bei welchem der wenigstens eine Farbfilter mehrere unterschiedlicher Farbfilter zum Filtern unterschiedlicher jeweiliger Lichtwellenlängen aufweist.

8.  CMOS-Bildsensor nach Anspruch 1, ferner aufweisend einen dritten Halbleiterchip (130"), der mit den ersten und zweiten Halbleiterchips im Stapel gekoppelt ist und mehrere Speicherschaltungen aufweist.

9.  CMOS-Bildsensor nach Anspruch 1, bei welchem die Bildverarbeitungsschaltung auch mehrere Transistoren aufweist, die jeweils einen Übergitterkanal enthalten.

10. CMOS-Bildsensor nach Anspruch 1, bei welchem die wenigstens eine Nicht-Halbleiter-Monoschicht Sauerstoff aufweist und die Halbleitermonoschichten Silizium aufweisen.

11. Verfahren zum Anfertigen eines in Anspruch 1 definierten CMOS-Bildsensors (100, 100', 100"), wobei das Verfahren aufweist:

Bilden eines ersten Halbleiterchips (101, 101', 101") mit einem Array von Bildsensorpixeln (102, 102', 102") und einer damit elektrisch verbundenen Ausleseschaltung (103, 103', 103");
Bilden eines zweiten Halbleiterchips (104, 104', 104"), der eine mit der Ausleseschaltung elektrisch verbundene Bildverarbeitungsschaltung aufweist; und
Zusammenkoppeln des ersten Halbleiterchips und des zweiten Halbleiterchips in einem Stapel;
wobei die Ausleseschaltung mehrere Transistoren (20) aufweist, die jeweils aufweisen:

beabstandete Source- und Drain-Bereiche (22, 23),
einen Übergitterkanal (25), der zwischen den Source- und Drain-Bereichen verläuft, wobei der Übergitterkanal mehrere Stapelgruppen von Schichten (45a-45n) aufweist, wobei jede Gruppe von Schichten mehrere gestapelte Basishalbleiter-Monoschichten (46), die einen Basishalbleiterabschnitt (46a-46n) definieren, und wenigstens eine Nicht-Halbleiter-Monoschicht (50), die in einem Kristallgitter von benachbarten Basishalbleiterabschnitten eingezwängt ist, aufweist, und
ein Gate (38) mit einer Gate-Isolierschicht (37) auf dem Übergitterkanal und einer Gate-Elektrode (36) auf der Gate-Isolierschicht.

12. Verfahren nach Anspruch 11, bei welchem das Bilden des ersten Halbleiterchips ferner ein Bilden einer elektrischen Verbindungsschicht (108) unter dem Array von Bildsensorpixeln damit ein Definieren einer Rückseitenbeleuchtungs-(BSI)-Konfiguration aufweist, wobei die elektrische Verbindungsschicht das Array von Bildsensorpixeln mit der Ausleseschaltung elektrisch verbindet.

**13.** Verfahren nach Anspruch 12, bei welchem das Bilden der elektrischen Verbindungsschicht ein Bilden einer Halbleiterschicht (109) und mehrerer beabstandeter Leiterspuren (110) in der Halbleiterschicht aufweist.

**14.** Verfahren nach Anspruch 11, ferner aufweisend ein Positionieren wenigstens einer Linse (112) über dem Array von Bildsensorpixeln.

**15.** Verfahren nach Anspruch 11, ferner aufweisend ein Positionieren wenigstens eines Farbfilters (111R, 111G,111B) über dem Array von Bildsensorpixeln.

**Revendications**

**1.** Capteur d'images CMOS (100, 100', 100") comprenant :

une première puce semi-conductrice (101, 101', 101") comprenant un réseau de pixels de capteur d'images (102, 102', 102") et une circuiterie de lecture (103, 103', 103") connectée électriquement à celui-ci ; et
une deuxième puce semi-conductrice (104, 104', 104") couplée à la première puce semi-conductrice dans un empilement et comprenant une circuiterie de traitement d'image connectée électriquement à la circuiterie de lecture,
**caractérisé en ce que** :
la circuiterie de lecture comprend une pluralité de transistors (20) comprenant chacun :

des régions de source et de drain espacées (22, 23),
un canal de superréseau (25) s'étendant entre les régions de source et de drain, le canal de superréseau comprenant une pluralité d'empilements de groupes de couches (45a - 45n), chaque groupe de couches comprenant une pluralité d'empilements de monocouches semi-conductrices de base (46) définissant une partie semi-conductrice de base (46a - 46n), et au moins une monocouche non semi-conductrice (50) contrainte à l'intérieur d'un réseau cristallin de parties semi-conductrices de base adjacentes, et
une grille (38) comprenant une couche isolante de grille (37) sur le canal de superréseau et une électrode de grille (36) sur la couche isolante de grille.

**2.** Capteur d'images CMOS selon la revendication 1, dans lequel la première puce semi-conductrice comprend en outre une couche d'interconnexion électrique (108) sous le réseau de pixels de capteur d'images et définissant une configuration de rétroéclairage (BSI) avec celui-ci, la couche d'interconnexion électrique connectant électriquement le réseau de pixels de capteur d'images avec la circuiterie de lecture.

**3.** Capteur d'images CMOS selon la revendication 2, dans lequel la couche d'interconnexion électrique comprend une couche semi-conductrice (109) et une pluralité de traces conductrices espacées (110) à l'intérieur de la couche semi-conductrice.

**4.** Capteur d'images CMOS selon la revendication 1, comprenant en outre au moins une lentille (112) recouvrant le réseau de pixels de capteur d'images.

**5.** Capteur d'images CMOS selon la revendication 1, comprenant en outre au moins un filtre de couleur (111R, 111G, 111B) recouvrant le réseau de pixels de capteur d'images.

**6.** Capteur d'images CMOS selon la revendication 5, dans lequel ledit au moins un filtre de couleur comprend un filtre de couleur respectif pour chacun des pixels dans le réseau de pixels de capteur d'images.

**7.** Capteur d'images CMOS selon la revendication 5, dans lequel ledit au moins un filtre de couleur comprend une pluralité de différents filtres de couleur pour filtrer différentes longueurs d'onde de lumière respectives.

**8.** Capteur d'images CMOS selon la revendication 1, comprenant en outre une troisième puce semi-conductrice (130") couplée aux première et deuxième puces semiconductrices dans l'empilement, et comprenant une pluralité de circuits de mémoire.

9. Capteur d'images CMOS selon la revendication 1, dans lequel la circuiterie de traitement d'image comprend également une pluralité de transistors incluant chacun un canal de superréseau.

10. Capteur d'images CMOS selon la revendication 1, dans lequel ladite au moins une monocouche non semi-conductrice comprend de l'oxygène et les monocouches semiconductrices comprennent du silicium.

11. Procédé de fabrication d'un capteur d'images CMOS (100, 100', 100") selon la revendication 1, le procédé consistant à :

former une première puce semi-conductrice (101, 101', 101") comprenant un réseau de pixels de capteur d'images (102, 102', 102") et une circuiterie de lecture (103, 103', 103") connectée électriquement à celui-ci ;
former une deuxième puce semi-conductrice (104, 104', 104") comprenant une circuiterie de traitement d'image connectée électriquement à la circuiterie de lecture ; et
coupler la première puce semi-conductrice et la deuxième puce semi-conductrice ensemble dans un empilement ;
la circuiterie de lecture comprenant une pluralité de transistors (20) comprenant chacun

des régions de source et de drain espacées (22, 23),
un canal de superréseau (25) s'étendant entre les régions de source et de drain, le canal de superréseau comprenant une pluralité d'empilements de groupes de couches (45a - 45n), chaque groupe de couches comprenant une pluralité d'empilements de monocouches semi-conductrices de base (46) définissant une partie semi-conductrice de base (46a - 46n), et au moins une monocouche non semi-conductrice (50) contrainte à l'intérieur d'un réseau cristallin de parties semi-conductrices de base adjacentes, et
une grille (38) comprenant une couche isolante de grille (37) sur le canal de superréseau et une électrode de grille (36) sur la couche isolante de grille.

12. Procédé selon la revendication 11, dans lequel la formation de la première puce semi-conductrice consiste en outre à former une couche d'interconnexion électrique (108) sous le réseau de pixels de capteur d'images et à définir une configuration de rétroéclairage (BSI) avec celui-ci, la couche d'interconnexion électrique connectant électriquement le réseau de pixels de capteur d'images avec la circuiterie de lecture.

13. Procédé selon la revendication 12, dans lequel la formation de la couche d'interconnexion électrique consiste à former une couche semi-conductrice (109) et une pluralité de traces conductrices espacées (110) à l'intérieur de la couche semi-conductrice.

14. Procédé selon la revendication 11, consistant en outre à positionner au moins une lentille (112) recouvrant le réseau de pixels de capteur d'images.

15. Procédé selon la revendication 11, consistant en outre à positionner au moins un filtre de couleur (111R, 111G, 111B) recouvrant le réseau de pixels de capteur d'images.

FIG. 1

FIG. 2

FIG. 3

FIG. 4A

FIG. 4B

FIG. 4C

**FIG. 5**

**FIG. 6**

FIG. 7

FIG. 8

**FIG. 9**

FIG. 10

FIG. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030057416 A, Currie
- US 20030034529 A, Fitzgerald
- US 6472685 B2, Takagi
- US 4937204 A, Ishibashi
- US 5357119 A, Wang
- US 5683934 A
- US 5216262 A
- WO 02103767 A1, Wang, Tsu and Lofgren
- GB 2347520 A, Mears
- US 6376337 B, Wang
- US 2016088253 A
- EP 1644984 A
- US 2015008482 A
- US 6897472 B, Mears
- US 20160336406 A
- US 20160336407 A, Mears

**Non-patent literature cited in the description**

- **TSU.** Phenomena in silicon nanostructure devices. *Applied Physics and Materials Science & Processing,* 06 September 2000, 391-402
- **LUO et al.** Chemical Design of Direct-Gap Light-Emitting Silicon. *Physical Review Letters,* 12 August 2002, vol. 89 (7